(19) Europäisches Patentamt
European Patent Office
Office européen des brevets

(11) EP 1 020 479 B1

(12) **EUROPÄISCHE PATENTSCHRIFT**

(45) Veröffentlichungstag und Bekanntmachung des Hinweises auf die Patenterteilung:
**10.08.2005 Patentblatt 2005/32**

(51) Int Cl.[7]: **C08F 2/50**, G03F 7/029, C07F 7/08

(21) Anmeldenummer: **99126253.6**

(22) Anmeldetag: **31.12.1999**

(54) **Photoinitiatoren zur kationischen Härtung**

Photoinitiators for cationic curing

Photoinitiateurs pour le durcissement cationique

(84) Benannte Vertragsstaaten:
**BE DE FR GB IT**

(30) Priorität: **16.01.1999 DE 19901531**

(43) Veröffentlichungstag der Anmeldung:
**19.07.2000 Patentblatt 2000/29**

(73) Patentinhaber: **Goldschmidt GmbH**
**45127 Essen (DE)**

(72) Erfinder:
- **Müller, Wolfgang**
**45141 Essen (DE)**
- **Oestreich, Sascha, Dr.**
**45279 Essen (DE)**

(56) Entgegenhaltungen:
**EP-A- 0 618 919**
**US-A- 4 513 137**
**US-A- 5 073 643**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 020 479 B1

## Beschreibung

Die Erfindung betrifft modifizierte, kationische Photoinitiatoren mit verringerter Kristallisationsneigung, ein Verfahren zur Verringerung der Kristallisationsneigung kationischer Photoinitiatoren und die Verwendung der erfindungsgemäßen Photoinitiatoren zur Strahlenhärtung kationisch härtender Massen.

Die kationische Photopolymerisation ist ein schneller, effizienter und umweltschonender Weg, um kationisch polymerisierbare Monomere zu härten. Besonders effiziente Photoinitiatoren stellen Diaryliodonium- (I) und Triarylsulfoniumsalze (II) dar.

$$Ar—I^{+}—Ar\ MX_n^{-} \qquad (I)$$

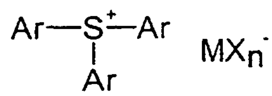

(II)

$$MX_n^{-} = BF_4^{-}, PF_6^{-}, AsF_6^{-}, SbF_6^{-}$$

Insbesondere Diaryliodoniumsalze (I) sind aus der Patentliteratur bekannt (DE-A-25 186 39, US-A-4 279 717, EP-A-0 334 056, EP-B-0 618 919) und werden als Photoinitiatoren zur Polymerisation von kationisch polymerisierbaren Substanzen verwendet. Die kationisch polymerisierbaren Substanzen sind aber unpolar bis wenig polar, besonders wenn die polymerisierbaren Gruppen in Organopolysiloxanen enthalten sind. Es wird daher beim Zusatz dieser Photoinitiatoren sehr häufig beobachtet, daß, abhängig von der Struktur der Zubereitung, die Mischbarkeit und Löslichkeit der Photoinitiatoren begrenzt ist. Daher werden die Arylreste solcher Oniumsalze oft mit Alkylketten substituiert, um die Löslichkeit in Organopolysiloxanen zu erhöhen (US-A-4 310 469 und US-A-4 374 066).

Diaryliodoniumsalze wie sie in US-A-5 073 643 beschrieben werden, sind ebenfalls durch Alkylketten hydrophob modifiziert. Zusätzlich tragen sie jedoch eine Hydroxylgruppe. Diese führt zu einer mangelhaften Mischbarkeit mit Organopolysiloxanen. Schon nach kurzer Zeit wird eine Trübung und ein Niederschlag des Photoinitiators beobachtet. Aufgrund ihrer Inhomogenität härten solche Beschichtungen bei UV-Bestrahlung nur schlecht aus. Es ist aber auch möglich, daß durch die Inhomogenität schon während der Applikation einer dünnen Schicht auf einem Substrat massive Oberflächenstörungen (Krater, Runzeln, Stippen etc.) auftreten.

Bei Hydroxylgruppen tragenden Iodoniumsalzen, wie sie in US-A-5 073 643 beschrieben werden, wird die schlechte Löslichkeit in unpolaren Medien auf die hohe Kristallisationsneigung zurückgeführt. Das besondere Komplexbildungsverhalten der Hydroxylgruppen tragenden Iodoniumsalze der allgemeinen Formel (III) führt zu einer starken Kristallisationsneigung der Verbindungen (A. Kunze, U. Müller, K. Tittes, J. P. Fonassier, F. Morlet-Savary, J. Photochemistry and Photobiology A: Chemistry, 110, 115-122 (1997)) :

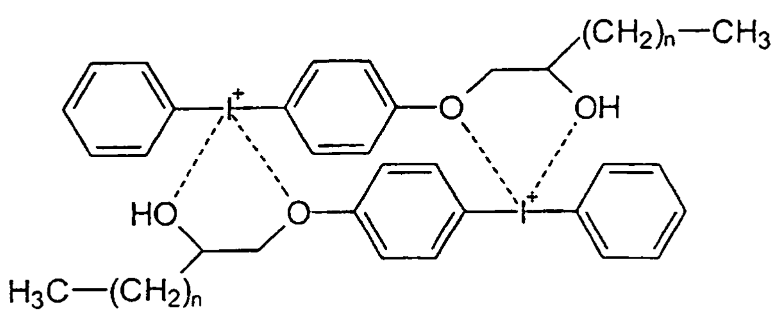

$$+ 2SbF_6^{-}$$

(III)

Die beiden Sauerstoffatome des Moleküls wirken als Liganden für ein zweites Iodonium-Ion. Durch dieses Aggregationsverhalten wird die Ausbildung von Kristallen gefördert.

Bei der Herstellung dieser Iodoniumsalze ist die starke Kristallisationsneigung durchaus erwünscht, da dadurch die Verbindungen durch einfache Umkristallisation in hoher Reinheit als Pulver gewonnen werden können. Auf diese Weise sind sie einfach und kostengünstig herstellbar. Solche Iodoniumsalze sind unter dem Handelsnamen CD-1012 von Sartomer kommerziell erhältlich.

Die hohe Kristallisationsneigung wirkt sich allerdings negativ aus, wenn diese Iodoniumsalze in unpolaren Medien, wie Organopolysiloxanen, gelöst werden sollen. Hier sind sie entweder unlöslich, oder es bildet sich schon nach kurzer Zeit ein fester Niederschlag.

Der Erfindung liegt die Aufgabe zugrunde, Hydroxylgruppen tragende Iodoniumsalze auf eine besonders kostengünstige, einfache Art zu modifizieren, so daß die Kristallisationsneigung stark herabgesetzt wird und eine gute Verträglichkeit mit Epoxygruppen aufweisenden Organopolysiloxanen hergestellt wird.

Die vorgenannte Aufgabe wird in einer ersten Ausführungform gelöst durch kationische Photoinitiatoren der allgemeinen Formel IV

$$[R^1—I—R^2]^+ X^- \qquad (IV)$$

wobei I für das Element Iod steht,
$X^-$ ein Anion eines komplexen Metallsalzes oder einer starken Säure ist,
$R^1$ für einen Rest

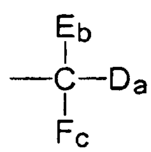

steht, worin C für einen einwertigen aromatischen Kohlenwasserstoffrest mit 6 bis 14 Kohlenstoffatomen je Rest oder einen einwertigen, wenigstens ein Sauerstoff- und/oder Schwefelatom enthaltenden aromatischen Kohlenwasserstoffrest mit 5 bis 15 Ringatomen je Rest steht,
a 1, 2 oder 3,
b 0, 1 oder 2,
c 0, 1 oder 2 sind,
D, E und F jeweils für Substituenten von C stehen, wobei D für einen Rest der Formel

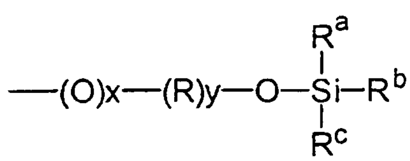

steht, wobei
x 0 oder 1,
y 0 oder 1 sind,
R für einen linearen oder verzweigten, zweiwertigen Kohlenwasserstoffrest mit 1 bis 40 Kohlenstoffatomen je Rest steht, der gegebenenfalls durch wenigstens ein Sauerstoffatom und/oder ein Schwefelatom und/oder eine Carboxylgruppe unterbrochen sein kann,
$R^a$, $R^b$, $R^c$ jeweils unabhängig ausgewählt sind aus der Gruppe einwertiger Alkyl-, Aryl-, Haloalkyl- oder Alkoxyradikale mit 1 bis 40 Kohlenstoffatomen,
E für einen Rest

$$—O—R^d$$

F für einen Rest

$$-R^e$$

$R^2$ für einen Rest

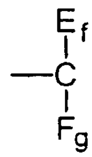

stehen, wobei

$R^d$ für einen einwertigen Kohlenwasserstoffrest mit 1 bis 18 Kohlenstoffatomen je Rest steht, der gegebenenfalls durch wenigstens ein Sauerstoffatom unterbrochen sein kann,

$R^e$ für einen einwertigen Kohlenwasserstoffrest mit 1 bis 18 Kohlenstoffatomen je Rest steht, der gegebenenfalls durch wenigstens ein Sauerstoffatom unterbrochen sein kann,

f 0,1 oder 2 und

g 0, 1 oder 2 sind.

Es wurde gefunden, daß durch die Modifizierung von Hydroxylgruppen enthaltenden, kationischen Photoinitiatoren die Kristallisationsneigung erheblich herabgesetzt und die Verträglichkeit mit Epoxygruppen aufweisenden Organopolysiloxanen wesentlich verbessert werden kann.

Bevorzugte Beispiele für aromatische Kohlenwasserstoffreste C sind der Phenyl-, Naphthyl- und Anthrylrest.

Bevorzugte Beispiele für wenigstens ein Sauerstoff- und/oder Schwefelatom enthaltende aromatische Kohlenwasserstoffreste C sind der 2-Furyl-, 3-Furyl-, 2-Thienyl- und 3-Thienylrest.

Bevorzugte Beispiele für den zweiwertigen Kohlenwasserstoffrest R, der durch wenigstens ein Sauerstoffatom und/oder Schwefelatom und/oder eine Carboxylgruppe unterbrochen sein kann, sind $-CH_2-$, $-CH_2-CH_2-$, $-CH_2-CH_2-O-CH_2-CH_2-$.

Bevorzugte Beispiele für Kohlenwasserstoffreste $R^a$, $R^b$, $R^c$ sind Alkylreste, wie der Methyl-, Ethyl-, n-Propyl-, iso-Propyl-, n-Butyl-, iso-Butyl-, tert.-Butyl-, n-Pentyl-, iso-Pentyl-, neo-Pentyl-, tert.-Pentylrest; Hexylreste, wie der n-Hexylrest; Heptylreste, wie der n-Heptylrest; Octylreste, wie der n-Octylrest und iso-Octylreste, wie der 2,2,4-Trimethylpentylrest; Nonylreste, wie der n-Nonylrest; Decylreste, wie der n-Decylrest; Dodecylreste, wie der n-Dodecylrest und Octyldecylreste, wie der n-Octadecylrest; Arylreste wie der Phenyl-, Naphthyl- und Anthrylrest.

Vorzugsweise enthalten alle drei am Si-Atom gebundenen Reste $R^a$,$R^b$,$R^c$ zusammen 3 bis 25 Kohlenstoffatome.

Die vorgenannten Beispiele für die Reste $R^a$,$R^b$,$R^c$ gelten in vollem Umfang auch für die Reste $R^d$ und $R^e$.

Bevorzugte Beispiele für durch wenigstens ein Sauerstoffatom und/oder Schwefelatom unterbrochene Kohlenwasserstoffreste $R^d$ und $R^e$ sind $-CH_2-CH_2-O-CH_3$, $-CH_2-CH_2O-CH_2CH_3$ und $-CH_2-CH_2-S-CH_2CH_3$.

Bevorzugte Beispiele für Reste D sind

$$-O(CH_2)_2-O-Si(CH_3)_3$$

$$-O(CH_2)_2-O-Si(CH_2CH_3)_3$$

$$-O(CH_2)_2-O-SiMe_2Oct$$

$$-O-(CH_2)_2-O-SiMe_2Ph$$

$$-O-(CH_2)_2-O-SiMePh_2$$

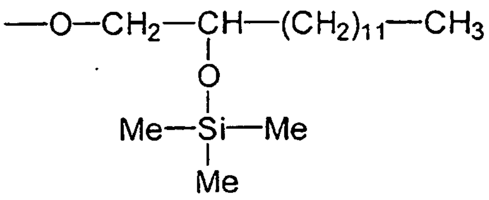

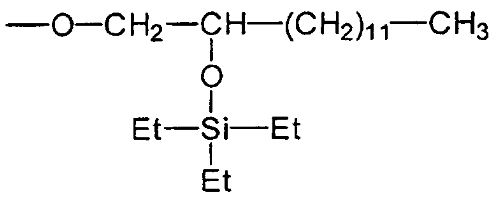

(worin Me Methylrest, Et Ethylrest, Ph Phenylrest, Oct n-Octylrest bedeutet).

Bevorzugte Beispiele für Reste E sind der Methoxy-, Ethoxy- und der n-Butoxyrest.

Bevorzugte Beispiele für Reste F sind der Methyl-, Ethyl-, Propyl-, 2-Methylpropyl- und der n-Butylrest.

Bevorzugte Beispiele für Reste $R^1$ sind

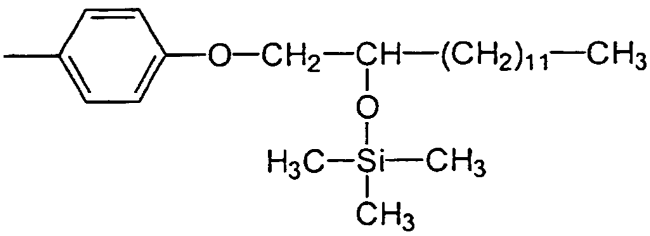

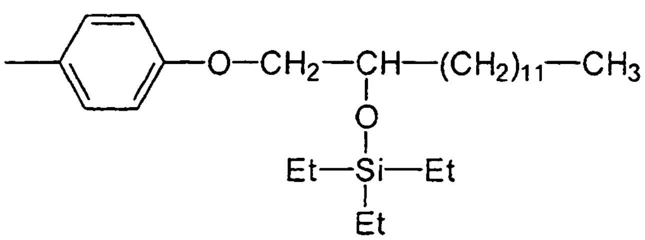

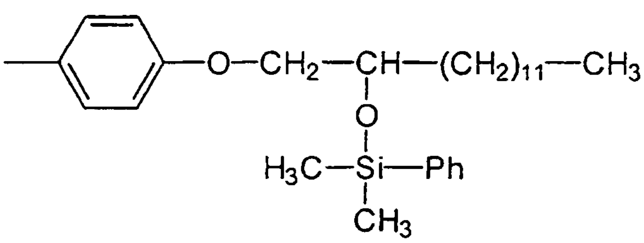

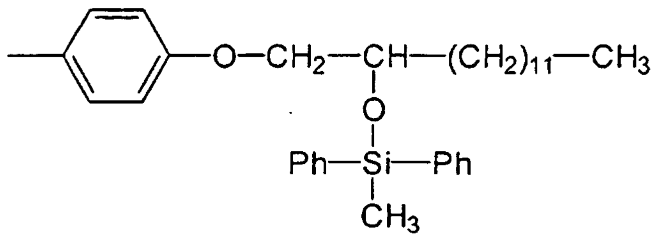

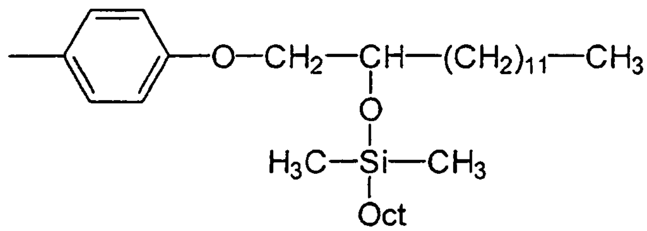

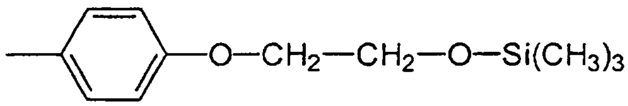

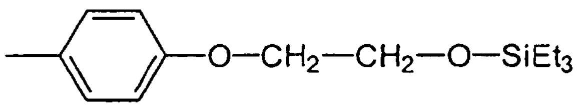

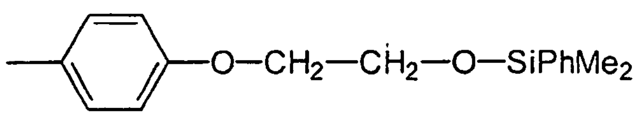

(worin Me, Et, Ph und Oct jeweils die obengenannte Bedeutung haben).

Bevorzugte Beispiele für Reste $R^2$ sind der Phenyl-, 4-Methylphenyl-, 3-Methoxyphenyl- und 4-Methoxyphenylrest.

Bevorzugte Beispiele für Anionen $X^-$ eines komplexen Metallsalzes oder einer starken Säure sind Tosylat, $SbF_6^-$, $PF_6^-$, $BF_4^-$, $F_3CSO_3^-$, $F_3CCO_2^-$, $AsF_6^-$, $ClO_4^-$, $HSO_4^-$. Starke Säure im Sinne der vorliegenden Erfindung umfassen insbesondere starke Brönstedt-Säuren.

Bevorzugt sind als kationische Photoinitiatoren mit verminderter Kristallisationsneigung solche der allgemeinen Formel V

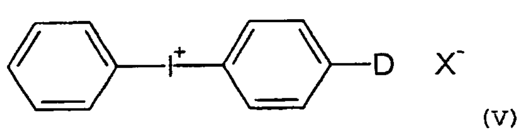

(V)

wobei D und $X^-$ die oben angegebene Bedeutung haben.

Besonders bevorzugt sind kationische Photoinitiatoren mit verminderter Kristallisationsneigung der nachfolgenden Formel VI

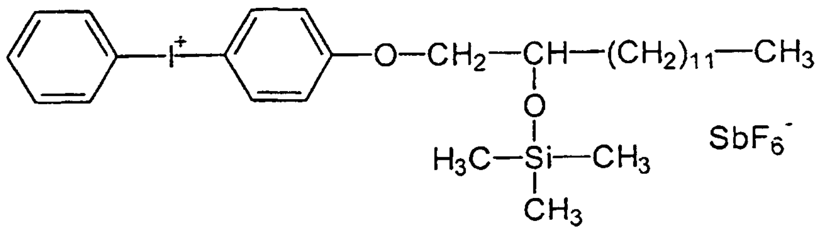

(VI)

Die Kristallisationsneigung der so modifizierten kationischen Photoinitiatoren ist gegenüber dem eingangs erwähnten Stand der Technik wesentlich herabgesetzt. Beispielsweise stellt dieses Iodoniumsalz bei Raumtemperatur eine viskose Flüssigkeit dar, während das vergleichbare Hydroxylgruppen enthaltende Iodoniumsalz mit der nachfolgenden Formel (VII)

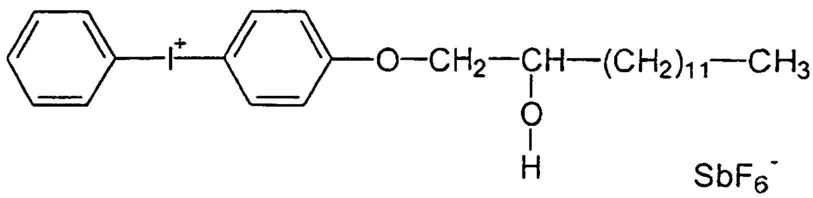

(VII)

ein Pulver mit einem Schmelzpunkt von 91°C darstellt, welches unter dem Handelsnamen CD-1012 von Sartomer erhältlich ist.

Ebenso ist die Löslichkeit der erfindungsgemäßen, kationischen Photoinitiatoren in unpolaren Medien, wie n-Alkanen oder Siloxanen, wesentlich größer als die der vergleichbaren Hydroxylgruppen enthaltenden kationischen Photoinitiatoren.

Beispielsweise ist das Iodoniumsalz der allgemeinen Formel (VI) unbegrenzt in Testbenzin löslich. Dagegen ist das vergleichbare, Hydroxylgruppen enthaltende Iodoniumsalz der allgemeinen Formel (VII) unlöslich in Testbenzin und zeigt keine Mischbarkeit mit Epoxygruppen enthaltenden Organopolysiloxanen.

Gegenstand der Erfindung ist weiterhin ein Verfahren zur Herstellung der kationischen Photoinitiatoren mit verminderter Kristallisationsneigung. Erfindungsgemäße kationische Photoinitiatoren werden bequemerweise durch eine Vielfalt von Routen hergestellt, wie unten angeben. Ein Hydroxylgruppen enthaltender kationischer Photoinitiator kann beispielsweise mit einem Chlorsilan, einem Chlorsiloxan, einem Silanol, einem Silylvinylether, einem Silazan oder einem cyclischen Siloxan reagieren.

"Si"— OR + Photo— OH → "Si"— OPhoto

"Si"— Cl + Photo— OH → "Si"— OPhoto

"Si"— OH + Photo— OH → "Si"— OPhoto

"Si"— OCH=CHR + Photo— OH → "Si"— OPhoto

"Si"— $NR_2$ + Photo— OH → "Si"— OPhoto

$$(\text{"Si"}—\text{O})_{(\text{cyclisch})} + \text{Photo}—\text{OH} \rightarrow \text{"Si"}—\text{OPhoto}$$

wobei "Si" einen allgemeinen Silanrest und "Photo" einen nichtmodifizierten Photoinitiatorrest bezeichnet.

Das erfindungsgemäße Verfahren ist dadurch gekennzeichnet, daß ein Hydroxylgruppen enthaltender Photoinitiator mit der allgemeinen Formel (IV')

$$[R^1—I—R^2]^+ X^- \qquad (IV')$$

wobei I für das Element Iod steht,
$X^-$ ein Anion eines komplexen Metallsalzes oder einer starken Säure ist,
$R^1$ für einen Rest

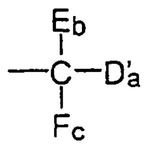

steht, worin C für einen einwertigen aromatischen Kohlenwasserstoffrest mit 6 bis 14 Kohlenstoffatomen je Rest oder einen einwertigen, wenigstens ein Sauerstoff- und/oder Schwefelatom enthaltenden aromatischen Kohlenwasserstoffrest mit 5 bis 15 Ringatomen je Rest steht,
a 1, 2 oder 3,
b 0, 1 oder 2,
c 0, 1 oder 2 sind,
D', E und F jeweils für Substituenten von C stehen, wobei D' für einen Rest

$$—(O)x—(R)y—OH$$

steht und
x 0 oder 1,
y 0 oder 1 sind,
R für einen linearen oder verzweigten, zweiwertigen Kohlenwasserstoffrest mit 1 bis 40 Kohlenstoffatomen je Rest steht, der gegebenenfalls durch wenigstens ein Sauerstoffatom und/oder ein Schwefelatom und/oder eine Carboxylgruppe unterbrochen sein kann,
E für einen Rest

$$—O—R^d$$

F für einen Rest

$$—R^e$$

$R^2$ für einen Rest

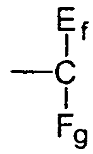

steht, wobei C, E, F die oben angegebene Bedeutung haben, $R^d$ für einen einwertigen Kohlenwasserstoffrest mit 1 bis 18 Kohlenstoffatomen je Rest steht, der gegebenenfalls durch wenigstens ein Sauerstoffatom unterbrochen sein kann,
$R^e$ für einen einwertigen Kohlenwasserstoffrest mit 1 bis 18 Kohlenstoffatomen je Rest steht, der gegebenenfalls durch wenigstens ein Sauerstoffatom unterbrochen sein kann,
f 0, 1 oder 2
g 0, 1 oder 2 sind, umgesetzt wird mit einem Chlorsilan, einem Silanol, einem Silylamin, einem Silylvinylether, einem Silazan und/oder einem cyclischen Siloxan.

Bevorzugt werden als Hydroxylgruppen enthaltende kationische Photoinitiatoren solche der allgemeinen Formel (V')

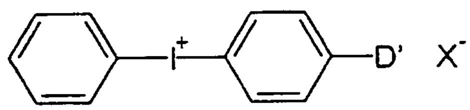

(V')

wobei D' und $X^-$ die oben dafür angegebene Bedeutung haben.

Besonders bevorzugte Ausgangsmaterialien sind Iodoniumsalze der nachfolgenden Formel (VI')

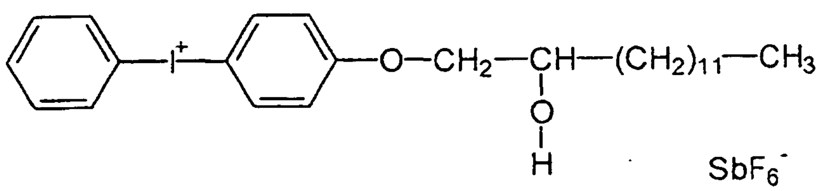

(VI')

Beispiele für Chlorsilane, die mit Hydroxylgruppen tragenden kationischen Photoinitiatoren umgesetzt werden können, sind solche mit der allgemeinen Formel (VIII)

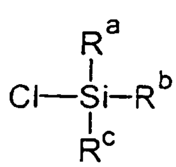

(VIII)

wobei $R^a$, $R^b$, $R^c$ jeweils unabhängig ausgewählt sind und die obengenannte Bedeutung haben.

Besonders bevorzugte Chlorsilane, die mit Hydroxylgruppen tragenden kationischen Photoinitiatoren umgesetzt werden können, sind Chlortrimethylsilan, (Chlormethyl)dimethylchlorsilan, (Brommethyl)dimethylchlorsilan, Dimethylethylchlorsilan, Triethylchlorsilan, Dimethylpropylchlorsilan, Tripropylchlorsilan, Isopropyldimethylchlorsilan, Triisopropylchlorsilan, 3-(Chlorpropyl)dimethylchlorsilan, Dimethyl(3,3,3-trifluorpropyl)chlorsilan, tert-Butyldimethylchlorsilan, tert.-Butyldiphenylchlorsilan, Butyldimethylchlorsilan, Tributylchlorsilan, Triisobutylchlorsilan, Dimethyl (3,3,4,4,5,5,6,6,6-nonafluorhexyl)chlorsilan, Hexyldimethylchlorsilan, Dimethyloctylchlorsilan, Diisopropyloctylchlorsilan, Decyldimethylchlorsilan, Dimethyldodecylchlorsilan, Dimethyloctadecylchlorsilan, Dimethylphenylchlorsilan, Diphenylmethylchlorsilan, Triphenylchlorsilan, (Pentafluorphenyl)-dimethylchlorsilan, Tribenzylchlorsilan, Dimethyl (2-phenylethyl)chlorsilan, Dimethylvinylchlorsilan, Allyldimethylchlorsilan.

Beispiele für Silazane, die mit Hydroxylgruppen tragenden kationischen Photoinitiatoren umgesetzt werden können, sind solche mit der allgemeinen Formel (IX)

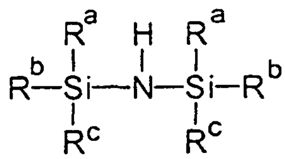

(IX)

wobei $R^a$, $R^b$, $R^c$ jeweils unabhängig ausgewählt sind und die obengenannte Bedeutung haben.

Besonders bevorzugte Silazane, die mit Hydroxylgruppen tragenden kationischen Photoinitiatoren umgesetzt werden können, sind Hexamethyldisilazan, 1,3-Bis(chloromethyl)-1,1,3,3-tetramethyldisilazan, Hexaethyldisilazan, 1,3-Dipropyl-1,1,3,3-Tetramethyldisilazan, 1,3-Dioctyl-1,1,3,3-tetramethyldisilazan, 1,3-Diphenyl-1,1,3,3-tetramethyldisilazan, 1,3-Dimethyl-1,1,3,3-tetraphenyldisilazan, 1,3-Divinyl-1,1,3,3-tetramethyldisilazan.

Beispiele für Silylamine sind solche mit der allgemeinen Formel (X)

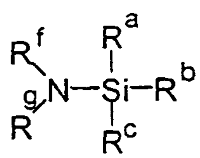

(X)

wobei $R^a$, $R^b$, $R^c$, $R^f$ und $R^g$ jeweils unabhängig ausgewählt sind und $R^f$ und $R^g$ die obengenannte Bedeutung von $R^a$ haben.

Besonders bevorzugte Silylamine, die mit Hydroxylgruppen tragenden kationischen Photoinitiatoren umgesetzt werden können, sind N,N-Dimethyl-trimethylsilylamin, N,N-Bis(trimethylsilyl)methylamin, N,N-Diethyltrimethylsilylamin, N-Benzyltrimethylsilylamin, 1-(Trimethylsilyl)imidazol, 4-(Trimethylsilyl)morpholin, 1-(Trimethylsilyl)pyrrolidin, N-(tert-Butyldimethylsilyl)dimethylamin, N-tert-Butyltri methylsilylamin, 1-(tert-Butyldimethylsilyl)imidazol, N-(Hexyldimethylsilyl)-dimethylamin, N-(Octyldiisopropylsilyl)dimethylamin, N-(Octadecyldiisobutylsilyl)-dimethylamin, N-(Octadecyldiisopropylsilyl)dimethylamin, Triphenylsilylamin.

Die Iodoniumsalze sind lichtempfindlich und zersetzen sich beispielsweise bei Bestrahlung mit Ultraviolettlicht nach einem mehrstufigen Mechanismus, der im Buch "UV-Curing: Science & Technology" von P. Pappas auf S. 34 beschrieben ist. Als aktives Endprodukt dieser Photolyse wird die entstandene Brönstedt-Säure, beispielsweise $HPF_6$, $HAsF_6$ angesehen, die ihrerseits die Polymerisation von kationisch polymerisierbaren Substanzen, wie Epoxiden oder Vinylethern, startet.

Die erfindungsgemäßen Iodoniumsalze eignen sich als Photoinitiatoren für die Polymerisation von kationisch polymerisierbaren organischen Substanzen, wie Epoxiden, Vinylethern, Epoxygruppen enthaltenden Organopolysiloxanen, Alkenyloxygruppen, wie Vinyloxygruppen oder Propenyloxygruppen, enthaltenden Organopolysiloxanen und Olefinen. Solche Substanzen sind beispielsweise in US-A-5 057 549, DE-A-40 02 922 sowie in den eingangs genannten Patentschriften enthalten.

Ausführungsbeispiele:

Beispiel 1

10g handelsüblicher Photoinitiator gemäß der Formel (VII) wurden in 20g THF gelöst und in die klare Lösung 2,78g Octyldimethylchlorsilan und wenige Tropfen N-Methylimidazol gegeben. Das Gemisch wurde auf 60°C im Wasserbad erwärmt und unter Stickstoffeinleitung 4h gerührt. Das Lösemittel THF wurde während dieser Zeit laufend ersetzt. Nach der Reaktion wurde das Lösemittel destillativ entfernt. Zurück blieb ein wachsartiges Produkt.

Beispiel 2

10g handelsüblicher Photoinitiator gemäß der Formel (VII) wurden in 20g THF gelöst und in die klare Lösung 10,81g Hexamethyldisilazan gegeben. Die Mischung wurde 1h gerührt, dann wurden überschüssiges Hexamethyldisilazan und Lösemittel im Vakuum entfernt. Zurück blieb ein gelbes, viskoses Produkt.

Beispiel 3

10g handelsüblicher Photoinitiator gemäß der Formel (VII) wurden in 20g THF gelöst und in die klare Lösung 11g Diphenyltetramethyldisilazan gegeben. Die Mischung wurde 1h gerührt, dann wurden überschüssiges Diphenyltetramethyldisilazan und Lösemittel im Vakuum entfernt. Zurück blieb ein bernsteinfarbenes, viskoses Produkt.

Beispiel 4

42g handelsüblicher Photoinitiator gemäß der Formel (VII) wurden in 80g THF gelöst und in die klare Lösung 24,4g N,N-Diethyltrimethylsilylamin gegeben. Die Mischung wurde 1h gerührt, dann wurden überschüssiges N, N-Diethyltrimethylsilylamin und Lösemittel destillativ im Vakuum entfernt. Zurück blieb ein rot-braunes, viskoses Produkt.

Vergleich 1

Die Löslichkeit der erfindungsgemäßen kationischen Photoinitiatoren wurde mit der Löslichkeit von handelsüblichen Hydroxylgruppen tragenden kationischen Photoinitiatoren verglichen. Die Ergebnisse sind in Tabelle 1 zusammengefaßt:

Tabelle 1

| Photoinitiator | Löslichkeit in Testbenzin |
|---|---|
| CD-1012 | unlöslich |
| Bsp. 1 | opak löslich |
| Bsp. 2 | klar löslich |
| Bsp. 3 | klar löslich |
| Bsp. 4 | klar löslich |

Der Löslichkeitsunterschied zwischen dem Hydroxylgruppen enthaltenden Photoinitiator CD-1012 und den erfindungsgemäßen, hydrophob modifizierten kationischen Photoinitiatoren ist beträchtlich.

Vergleich 2

Die Verminderung der Kristallisationsneigung läßt sich besonders deutlich anhand des Schmelzpunktes der Verbindungen zeigen.

Tabelle 2

| Photoinitiator | Schmelzpunkt |
|---|---|
| CD-1012 | 91 °C |

Tabelle 2 (fortgesetzt)

| Photoinitiator | Schmelzpunkt |
|---|---|
| Bsp. 1 | viskoses Öl |
| Bsp. 2 | viskoses Öl |
| Bsp. 3 | viskoses Öl |
| Bsp. 4 | viskoses Öl |

Es zeigte sich, daß durch die Modifikation der Schmelzpunkt und damit die Kristallisationsneigung erheblich herabgesetzt wurde.

## Patentansprüche

**1.** Kationische Photoinitiatoren der allgemeinen Formel IV

$$[R^1—I—R^2]^+ X^- \qquad (IV)$$

wobei I für das Element Iod steht,
$X^-$ ein Anion eines komplexen Metallsalzes oder einer starken Säure ist,
$R^1$ für einen Rest

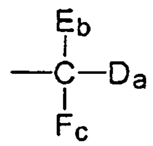

steht, worin C für einen einwertigen aromatischen Kohlenwasserstoffrest mit 6 bis 14 Kohlenstoffatomen je Rest oder einen einwertigen, wenigstens ein Sauerstoff- und/oder Schwefelatom enthaltenden aromatischen Kohlenwasserstoffrest mit 5 bis 15 Ringatomen je Rest steht,
a 1, 2 oder 3,
b 0, 1 oder 2,
c 0, 1 oder 2 sind,
D, E und F jeweils für Substituenten von C stehen, wobei
D für einen Rest

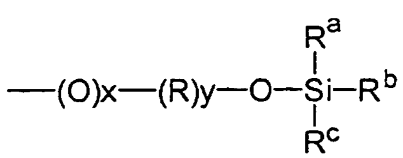

steht, wobei
x 0 oder 1,
y 0 oder 1 sind,
R für einen linearen oder verzweigten, zweiwertigen Kohlenwasserstoffrest mit 1 bis 40 Kohlenstoffatomen je Rest steht, der gegebenenfalls durch wenigstens ein Sauerstoffatom und/oder ein Schwefelatom und/oder eine Carboxylgruppe unterbrochen sein kann,
$R^a$, $R^b$, $R^c$ jeweils unabhängig ausgewählt sind aus der Gruppe einwertiger Alkyl-, Aryl-, Haloalkyl- oder Alkoxyradikale mit 1 bis 40 Kohlenstoffatomen,
E für einen Rest

$$—O—R^d$$

F für einen Rest

$$—R^e$$

$R^2$ für einen Rest

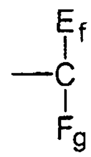

stehen, wobei
$R^d$ für einen einwertigen Kohlenwasserstoffrest mit 1 bis 18 Kohlenstoffatomen je Rest steht, der gegebenenfalls durch wenigstens ein Sauerstoffatom unterbrochen sein kann,
$R^e$ für einen einwertigen Kohlenwasserstoffrest mit 1 bis 18 Kohlenstoffatomen je Rest steht, der gegebenenfalls durch wenigstens ein Sauerstoffatom unterbrochen sein kann,
f 0, 1 oder 2 und
g 0, 1 oder 2 sind.

**2.** Photoinitiator nach Anspruch 1, **dadurch gekennzeichnet, daß** der aromatische Kohlenwasserstoffrest C für Phenyl, Naphthyl und Anthryl steht.

**3.** Photoinitiator nach Anspruch 1, **dadurch gekennzeichnet, daß** der Rest D für

$$-O(CH_2)_2-O-Si(CH_3)_3$$

$$-O(CH_2)_2-O-Si(CH_2CH_3)_3$$

$$-O(CH_2)_2-O-SiMe_2Oct$$

$$-O-(CH_2)_2-O-SiMe_2Ph$$

$$-O-(CH_2)_2-O-SiMePh_2$$

steht.

**4.** Photoinitiator nach Anspruch 1, **dadurch gekennzeichnet, daß** die Reste $R^2$ ausgewählt sind aus Phenyl, 4-Methylphenyl, 3-Methoxyphenyl und 4-Methoxyphenyl.

**5.** Photoinitiator nach Anspruch 1, **dadurch gekennzeichnet, daß** das Anion $X^-$ für ein komplexes Metallsalz oder eine starke Säure ausgewählt ist aus Tosylat, $SbF_6^-$, $PF_6^-$, $BF_4^-$, $F_3CSO_3^-$, $F_3CCO_2^-$, $AsF_6^-$, $ClO_4^-$, $HSO_4$ steht.

**6.** Verfahren zur Herstellung von Photoinitiatoren der allgemeinen Formel IV' **dadurch gekennzeichnet, daß** ein Hydroxylgruppen enthaltender Photoinitiator mit der allgemeinen Formel (IV')

$$[R^1-I-R^2]^+ X^- \qquad (IV')$$

wobei I für das Element Iod steht,
$X^-$ ein Anion eines komplexen Metallsalzes oder einer starken Säure ist,
$R^1$ für einen Rest

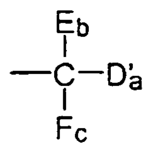

steht, worin C für einen einwertigen aromatischen Kohlenwasserstoffrest mit 6 bis 14 Kohlenstoffatomen je Rest oder einen einwertigen, wenigstens ein Sauerstoff- und/oder Schwefelatom enthaltenden aromatischen Kohlenwasserstoffrest mit 5 bis 15 Ringatomen je Rest steht,
a 1, 2 oder 3,
b 0, 1 oder 2,
c 0, 1 oder 2 sind,
D', E und F jeweils für Substituenten von C stehen, wobei
D' für einen Rest

$$-(O)x-(R)y-OH$$

steht und
x 0 oder 1,
y 0 oder 1 sind,
R für einen linearen oder verzweigten, zweiwertigen Kohlenwasserstoffrest mit 1 bis 40 Kohlenstoffatomen je Rest steht, der gegebenenfalls durch wenigstens ein Sauerstoffatom und/oder ein Schwefelatom und/oder eine Carboxylgruppe unterbrochen sein kann,
E für einen Rest

$$-O-R^d$$

F für einen Rest

$$-R^e$$

$R^2$ für einen Rest

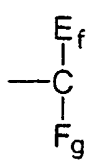

steht, wobei C, E, F die oben angegebene Bedeutung haben,
$R^d$ für einen einwertigen Kohlenwasserstoffrest mit 1 bis 18 Kohlenstoffatomen je Rest steht, der gegebenenfalls durch wenigstens ein Sauerstoffatom unterbrochen sein kann,
$R^e$ für einen einwertigen Kohlenwasserstoffrest mit 1 bis 18 Kohlenstoffatomen je Rest steht, der gegebenenfalls

durch wenigstens ein Sauerstoffatom unterbrochen sein kann,
f 0, 1 oder 2
g 0, 1 oder 2 sind,
umgesetzt wird mit einem Chlorsilan, einem Silanol, einem Silylamin, einem Silylvinylether, einem Silazan und/oder einem cyclischen Siloxan.

**7.** Verwendung von Photoinitiatoren nach einem der Ansprüche 1 bis 5 zur Polymerisation von kationisch polymerisierbaren Substanzen, insbesondere Epoxiden, Vinylethern, Epoxygruppen enthaltenen Organopolysiloxanen, Alkenyloxygruppen, insbesondere Vinyloxygruppen oder Propenyloxygruppen enthaltenden Polysiloxanen und Olefinen.

## Claims

**1.** Cationic photoinitiator of the general formula IV

$$[R^1—I—R^2]^+ X^- \qquad (IV)$$

where I is the element iodine,
$X^-$ is the anion of a complex metal salt or of a strong acid,
$R^1$ is a radical

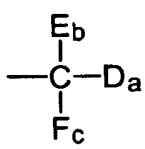

in which C is a monovalent aromatic hydrocarbon radical having 6 to 14 carbon atoms per radical or is a monovalent aromatic hydrocarbon radical containing at least one oxygen and/or sulfur atom and having 5 to 15 ring atoms per radical,
a is 0, 1, 2 or 3,
b is 0, 1 or 2,
c is 0, 1 or 2,
D, E and F are each substituents of C,
D being a radical >

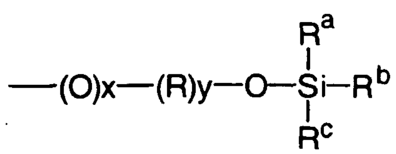

where
x is 0 or 1,
y is 0 or 1,
R is a linear or branched divalent hydrocarbon radical having 1 to 40 carbon atoms per radical, which can be interrupted if desired by at least one oxygen atom and/or one sulphur atom and/or one carboxyl group,
$R^a$, $R^b$ and $R^c$ each independently are selected from the group consisting of monovalent alkyl, aryl, haloalkyl and alkoxy radicals having 1 to 40 carbon atoms,
E is a radical

$-O-R^d$,

F is a radical

$-R^e$,

$R^2$ is a radical

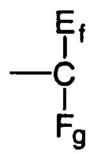

where
$R^d$ is a monovalent hydrocarbon radical having 1 to 18 carbon atoms per radical, which can be interrupted if desired by at least one oxygen atom,
$R^e$ is a monovalent hydrocarbon radical having 1 to 18 carbon atoms per radical, which can be interrupted if desired by at least one oxygen atom,
f is 0, 1 or 2, and
g is 0, 1 or 2.

**2.** Photoinitiator according to Claim 1, **characterized in that** the aromatic hydrocarbon radical C is phenyl, naphthyl or anthryl.

**3.** Photoinitiator according to Claim 1, **characterized in that** the radical D is

$-O(CH_2)_2-O-Si(CH_3)_3$
$-O(CH_2)_2-O-Si(CH_2CH_3)_3$
$-O(CH_2)_2-O-SiMe_2Oct$
$-O-(CH_2)_2-O-SiMe_2Ph$
$-O-(CH_2)_2-O-SiMePh_2$.

**4.** Photoinitiator according to Claim 1, **characterized in that** the radicals $R^2$ are selected from phenyl, 4-methylphenyl, 3-methoxyphenyl and 4-methoxyphenyl.

**5.** Photoinitiator according to Claim 1, **characterized in that** the anion $X^-$ of a complex metal salt or of a strong acid is selected from tosylate, $SbF_6^-$, $PF_6^-$, $BF_4^-$, $F_3CSO_3^-$,
$F_3CCO_2^-$, $AsF_6^-$, $ClO_4^-$, and $HSO_4^-$.

**6.** Process for preparing a photoinitiator of the general formula IV', **characterized in that** a hydroxyl-containing photoinitiator having the general formula (IV')

$$[R^1-I-R^2]^+ X^- \qquad (IV')$$

in which I is the element iodine,
$X^-$ is the anion of a complex metal salt or of a strong acid,
$R^1$ is a radical

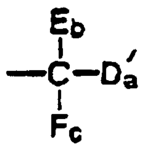

in which C is a monovalent aromatic hydrocarbon radical having 6 to 14 carbon atoms per radical or is a monovalent aromatic hydrocarbon radical containing at least one oxygen and/or sulphur atom and having 5 to 15 ring atoms per radical,
a is 0, 1, 2 or 3,
b is 0, 1 or 2,
c is 0, 1 or 2,
D', E and F are each substituents of C,
D' being a radical

$$—(O)x—(R)y—OH$$

where
x is 0 or 1,
y is 0 or 1,
R is a linear or branched divalent hydrocarbon radical having 1 to 40 carbon atoms per radical, which can be interrupted if desired by at least one oxygen atom and/or one sulphur atom and/or one carboxyl group,
E is a radical

$$—O—R^d,$$

F is a radical

$$—R^e,$$

$R^2$ is a radical

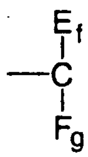

where
C, E and F are as defined above,
$R^d$ is a monovalent hydrocarbon radical having 1 to 18 carbon atoms per radical, which can be interrupted if desired by at least one oxygen atom,
$R^e$ is a monovalent hydrocarbon radical having 1 to 18 carbon atoms per radical, which can be interrupted if desired by at least one oxygen atom,
f is 0, 1 or 2, and
g is 0, 1 or 2 ,
is reacted with a chlorosilane, a silanol, a silylamine, a silyl vinyl ether, a silazane and/or a cyclic siloxane.

**7.** Use of a photoinitiator according to any of Claims 1 to 5 for polymerizing cationically polymerizable substances, especially epoxides, vinyl ethers, organopolysiloxanes containing epoxy groups, polysiloxanes containing alkenyloxy groups, especially vinyloxy or propenyloxy groups, and olefins.

## Revendications

**1.** Photo-initiateurs cationiques de formule générale IV

$$[R^1—I—R^2]^+ X^- \quad (IV)$$

où I représente l'élément iode,
$X^-$ représente un anion d'un sel métallique complexe ou d'un acide fort,
$R^1$ représente un radical

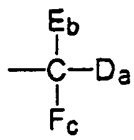

où C représente un radical hydrocarboné monovalent aromatique comprenant 6 à 14 atomes de carbone par radical ou un radical hydrocarboné aromatique monovalent, contenant au moins un atome d'oxygène et/ou un atome de soufre comprenant 5 à 15 atomes de cycle par radical,
a représente 0, 1, 2 ou 3,
b représente 0, 1 ou 2,
c représente 0, 1 ou 2,
D, E et F représentent à chaque fois des substituants pour C, où
D représente un radical

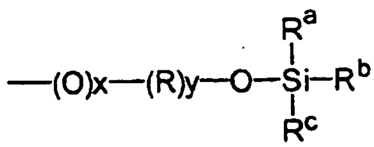

où
x représente 0 ou 1,
y représente 0 ou 1,
R représente un radical hydrocarboné linéaire ou ramifié, divalent, comprenant 1 à 40 atomes de carbone par radical, qui peut le cas échéant être interrompu par au moins un atome d'oxygène et/ou un atome de soufre et/ou un groupe carboxyle,
$R^a$, $R^b$, $R^c$ sont choisis, à chaque fois indépendamment, dans le groupe constitué par les radicaux alkyle, aryle, halogénoalkyle ou alcoxy monovalents, comprenant 1 à 40 atomes de carbone,
E représente un radical

$$-O-R^d$$

F représente un radical

$$-R^e$$

$R^2$ représente un radical

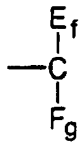

où
$R^d$ représente un radical hydrocarboné monovalent comprenant 1 à 18 atomes de carbone par radical, qui peut le cas échéant être interrompu par au moins un atome d'oxygène,
$R^e$ représente un radical hydrocarboné monovalent comprenant 1 à 18 atomes de carbone par radical, qui peut le cas échéant être interrompu par au moins atome d'oxygène,
f représente 0, 1 ou 2 et
g représente 0, 1 ou 2.

**2.** Photo-initiateur selon la revendication 1, **caractérisé en ce que** le radical hydrocarboné aromatique C représente phényle, naphtyle et anthryle.

**3.** Photo-initiateur selon la revendication 1, **caractérisé en ce que** le radical D représente

$$-O-(CH_2)_2-O-Si(CH_3)_3$$

$$-O-(CH_2)_2-O-Si(CH_2CH_3)_3$$

$$-O-(CH_2)_2-O-SiMe_2Oct$$

$$-O-(CH_2)_2-O-SiMe_2Ph$$

$$-O-(CH_2)_2-O-SiMePh_2.$$

**4.** Photo-initiateur selon la revendication 1, **caractérisé en ce que** les radicaux $R^2$ sont choisis parmi phényle, 4-méthylphényle, 3-méthoxyphényle et 4-méthoxyphényle.

**5.** Photo-initiateur selon la revendication 1, **caractérisé en ce que** l'anion $X^-$ représente un sel métallique complexe ou un acide fort, choisi parmi tosylate, $SbF_6^-$, $PF_6^-$, $BF_4^-$, $F_3CSO_3^-$, $F_3CCO_2^-$, $AsF_6^-$ , $ClO_4^-$, $HSO_4^-$.

**6.** Procédé pour la préparation de photo-initiateurs de formule générale IV', **caractérisé en ce qu'**on transforme un photo-initiateur contenant des groupes hydroxyle de formule générale (IV')

$$[R^1—I—R^2]^+ X^- \qquad (IV')$$

où I représente l'élément iode,
$X^-$ représente un anion d'un sel métallique complexe ou un acide fort,
$R^1$ représente un radical

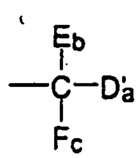

où C représente un radical hydrocarboné monovalent aromatique comprenant 6 à 14 atomes de carbone par radical ou un radical hydrocarboné aromatique monovalent, contenant au moins un atome d'oxygène et/ou un atome de soufre comprenant 5 à 15 atomes de cycle par radical,
a représente 0, 1, 2 ou 3,
b représente 0, 1 ou 2,
c représente 0, 1 ou 2,
D', E et F représentent à chaque fois des substituants pour C, où
D' représente un radical

$$-(O)_x-(R)_y-OH$$

et
x représente 0 ou 1,
y représente 0 ou 1,
R représente un radical hydrocarboné linéaire ou ramifié, divalent, comprenant 1 à 40 atomes de carbone par radical, qui peut le cas échéant être interrompu par au moins un atome d'oxygène et/ou un atome de soufre et/ou un groupe carboxyle,
E représente un radical

$$-O-R^d$$

F représente un radical

$$-R^e$$

$R^2$ représente un radical

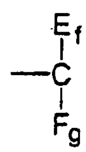

où C, E, F ont la signification susmentionnée,
$R^d$ représente un radical hydrocarboné monovalent comprenant 1 à 18 atomes de carbone par radical, qui peut le cas échéant être interrompu par au moins un atome d'oxygène,
$R^e$ représente un radical hydrocarboné monovalent comprenant 1 à 18 atomes de carbone par radical, qui peut le cas échéant être interrompu par au moins atome d'oxygène,
f représente 0, 1 ou 2 et
g représente 0, 1 ou 2
avec un chlorosilane, un silanol, une silylamine, un silylvinyléther, un silazane et/ou un siloxane cyclique.

**7.** Utilisation de photo-initiateurs selon l'une quelconque des revendications 1 à 5 pour la polymérisation de substances polymérisables par voie cationique, en particulier d'époxydes, de vinyléthers, d'organopolysiloxanes contenant des groupes époxy, de polysiloxanes contenant des groupes alcényloxy, en particulier des groupes vinyloxy ou propényloxy et d'oléfines.